(19) **Europäisches Patentamt / European Patent Office / Office européen des brevets**

(11) **EP 4 587 848 B1**

(12) **FASCICULE DE BREVET EUROPEEN**

(45) Date de publication et mention de la délivrance du brevet:
**28.01.2026 Bulletin 2026/05**

(21) Numéro de dépôt: **23812908.4**

(22) Date de dépôt: **23.11.2023**

(51) Classification Internationale des Brevets (IPC):
**G01R 15/18** (2006.01)  **H01F 1/00** (2006.01)
**H01F 3/08** (2006.01)  **H01F 3/10** (2006.01)
**H01F 5/02** (2006.01)

(52) Classification Coopérative des Brevets (CPC):
**G01R 15/185; H01F 1/0018; H01F 5/02;** H01F 3/10

(86) Numéro de dépôt international:
**PCT/EP2023/082783**

(87) Numéro de publication internationale:
**WO 2024/132354 (27.06.2024 Gazette 2024/26)**

(54) **CAPTEUR DE CIRCULATION DU CHAMP MAGNETIQUE COMPRENANT TRANSDUCTEUR SUPERPARAMAGNETIQUE POUR LA MESURE D'UN COURANT CONTINU**

MAGNETFELD-ZIRKULATIONSSENSOR UMFASSEND SUPERPARAMAGNETISCHEN WANDLER ZUR MESSUNG EINES GLEICHSTROMS

MAGNETIC FIELD CIRCULATION SENSOR COMPRISING SUPERPARAMAGNETIC TRANSDUCER FOR MEASURING A DIRECT CURRENT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.12.2022 FR 2214299**

(43) Date de publication de la demande:
**23.07.2025 Bulletin 2025/30**

(73) Titulaire: **Socomec**
**67230 Benfeld (FR)**

(72) Inventeur: **KERN, Christian**
**68240 KAYSERSBERG-VIGNOBLE (FR)**

(74) Mandataire: **Ipsilon**
**Boîte Postale CS 91455**
**34 Avenue du Général Leclerc**
**68071 Mulhouse Cedex (FR)**

(56) Documents cités:
**EP-B1- 3 477 311**   **WO-A1-2022/129732**
**US-A1- 2012 038 360**   **US-A1- 2015 108 974**
**US-B2- 8 076 932**

## Description

### Domaine technique

La présente invention se rapporte au domaine de la mesure sans contact d'un courant électrique circulant dans un conducteur par l'intermédiaire de la mesure de la circulation du champ magnétique induit par ce courant. L'invention concerne plus particulièrement un capteur de circulation du champ magnétique intégrant au moins un transducteur à base d'un matériau superparamagnétique, adapté pour la mesure de courant continu.

### Art antérieur

Pour mesurer un courant I, différents principes physiques peuvent être exploités pour générer une grandeur physique représentative de ce courant I. Par exemple, les capteurs magnétiques mettent en œuvre des transducteurs qui sont sensibles à des grandeurs magnétiques, tels que la circulation du champ magnétique, induites par le courant à mesurer.

On connaît notamment les capteurs de courant mettant en œuvre la technologie dite à Effet Néel® décrite par exemple dans le document FR2891917. La particularité de cette technologie repose sur l'utilisation d'un transducteur constitué de bobines dont les noyaux sont à base d'un composite chargé de nanoparticules présentant des propriétés superparamagnétiques (SPM).

De manière traditionnelle, un tel transducteur superparamagnétique (SPM) est formé d'un conducteur filaire enroulé autour et le long d'un noyau magnétique souple et allongé. Le bobinage réalisé le long du noyau magnétique assure une double fonction de bobine d'excitation et de mesure. Il est néanmoins d'usage de mettre en œuvre des moyens de contre-réaction adaptés pour maintenir la circulation du champ magnétique dans le noyau à une valeur sensiblement nulle. La bobine d'excitation peut être utilisée pour assurer la fonction de contre-réaction, mais il est également possible de prévoir un bobinage spécifique superposé au bobinage d'excitation pour faire office de bobine de contre-réaction.

L'utilisation de ce type de transducteur a l'avantage de ne pas présenter d'offset magnétique, puisqu'un matériau SPM a la particularité d'être exempt d'hystérésis.

Cependant, les caractéristiques des matériaux SPM sont telles qu'il est nécessaire de faire un compromis entre dynamique de mesure et sensibilité. En effet, l'aimantation M(H) d'un matériau SPM suit sensiblement une fonction de Langevin.

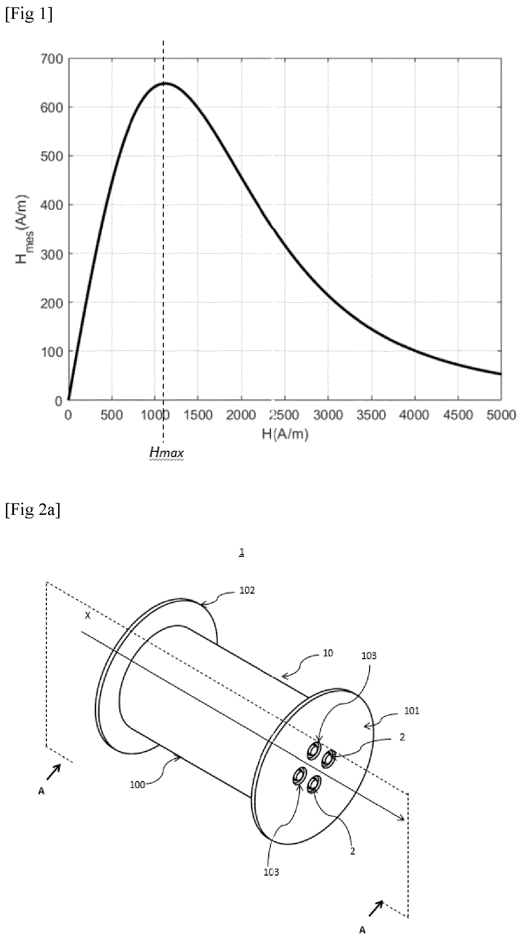

La figure 1 présente la relation entre champ primaire $H(A/m)$ et champ mesuré $H_{mes}(A/m)$ avec un capteur en boucle ouverte basé sur un matériau SPM connu. Dans le cas illustré à la figure 1, on constate que la plage de linéarité est très réduite, et que la relation n'est pas bijective, chaque valeur de champ mesurée pouvant correspondre à deux valeurs de champ primaire. Dans l'exemple illustré à la figure 1, la plage de linéarité, et donc la plage de mesure, est limitée à $H_{max}$ = 1100 A/m.

Ainsi, l'utilisation de matériau SPM présentant une valeur $H_{max}$ faible, par exemple 1100 A/m, permet d'avoir une bonne sensibilité mais la plage de mesure reste restreinte, et n'est donc pas adaptée pour la mesure de circulation du champ présentant une grande variation de champ le long du contour de mesure.

L'utilisation de matériaux présentant une valeur $H_{max}$ plus élevée, par exemple 10 kA/m, pour avoir une plage de linéarité plus grande, diminuera cependant la sensibilité du transducteur, et n'est donc pas adaptée à la mesure de petits courants.

Le document EP 3 477 311 B1 propose un capteur de courant comprenant un circuit magnétique formé autour d'un conducteur primaire, une bobine-sonde disposée sur le circuit magnétique, et un enroulement secondaire qui génère, dans le circuit magnétique, un champ magnétique dans une direction opposée à une direction d'un champ magnétique généré par le flux du courant primaire. Ce capteur de courant est relativement volumineux, et ne permet pas d'effectuer une mesure suffisamment précise.

Le document US 2012/038360 A1 propose un capteur du courant circulant dans un conducteur électrique. Ce capteur comprend un noyau superparamagnétique qui forme un circuit fermé comprenant une âme en forme de « U » et un arceau, ces deux éléments pouvant être désolidarisés afin de pouvoir insérer le conducteur à l'intérieur du circuit magnétique. Ce capteur, afin de fonctionner, nécessite un noyau de section importante présentant une concentration élevée de matériau SPM, soit une grande quantité de matériau SPM, ce qui en fait une solution très chère.

Le document WO 2022/129732 A1 propose un capteur de courant comportant une paire de bobines comprenant chacune un noyau superparamagnétique. Le capteur comprend également trois moyens d'excitation des bobines en courant, ce qui est lourd à fabriquer. De plus, la précision des mesures d'un tel capteur n'est pas satisfaisante.

### Exposé de l'invention

La présente invention vise donc à proposer une configuration alternative de capteur de circulation du champ magnétique continu ou du courant continu, à base de matériau SPM.

En particulier, la présente invention vise à proposer une configuration qui tire avantage des caractéristiques intéressantes des transducteurs SPM à circulation de champ nul, principalement leur absence d'offset magnétique, tout en présentant un encombrement réduit et une solution économique rentable.

L'invention a ainsi pour objet un capteur de circulation du champ magnétique pour la mesure d'un courant continu, formé d'au moins un transducteur à matériau superparamagnétique SPM, tel que défini par la revendication indépendante 1.

Ainsi le transducteur SPM de l'invention est de dimension finie et est formé d'un corps rigide configuré pour porter le bobinage de contre-réaction sur sa surface externe, ainsi que le ou les bobine(s) SPM dans un canal ou des canaux formé(s) dans son volume interne.

Cette configuration est différente de celle de l'art antérieur qui se présente généralement sous la forme d'un long câble flexible, les conducteurs d'excitation, de mesure et de contre-réaction étant enroulés successivement en couches autour du noyau SPM.

Le corps peut être sous la forme d'un cylindre. La longueur du corps, dans la direction de l'axe central longitudinal, peut être de quelques centimètres à une dizaine de centimètres.

Avantageusement, le transducteur comprend plusieurs canaux support distincts, par exemple deux, chaque canal logeant une bobine SPM. Les canaux support s'étendent parallèlement à l'axe central longitudinal et sont disposés dans le corps autour de l'axe central longitudinal, chaque canal débouchant au niveau des deux faces planes du corps.

Avantageusement, les deux faces planes délimitent avec la surface externe du corps un volume externe, le bobinage de contre-réaction étant contenu dans ce volume externe.

Selon un mode de réalisation, le corps est formé d'une première sous-structure comprenant le ou les canaux support et d'une deuxième sous-structure creuse comprenant les deux faces planes ainsi que la surface externe supportant le bobinage de contre-réaction. La première sous-structure est insérée dans le volume creux de la deuxième sous-structure. En particulier, la première sous-structure est formée d'un corps support rigide dans lequel sont creusés les canaux support qui sont ouverts radialement vers la surface externe du corps de la première sous-structure et qui débouchent aux deux extrémités dudit corps de la première sous-structure.

Selon l'invention, le capteur comprend au moins :

- un transducteur SPM présentant un axe central longitudinal X et deux extrémités libres opposées suivant l'axe central longitudinal X, le transducteur SPM étant formé d'un bobinage de contre-réaction CR couplé à au moins une bobine SPM s'étendant entre les deux extrémités libres ;
- un circuit magnétique présentant au moins deux surfaces planes parallèles entre elles et perpendiculaires à l'axe central longitudinal X, les deux surfaces planes étant positionnées en regard des extrémités libres respectives du transducteur.

En outre, selon l'invention, le capteur est destiné à être positionné par rapport au conducteur primaire de sorte que ledit axe Z est perpendiculaire à l'axe longitudinal X et parallèle aux surfaces planes.

En pratique, la portion du conducteur primaire est destinée à être parcourue par un courant. Le transducteur SPM est formé d'une ou de plusieurs bobine(s) SPM s'étendant suivant un axe longitudinal, et couplée(s) à un bobinage de contre-réaction. Le bobinage de contre-réaction CR est formé par un enroulement d'un conducteur électrique réalisé autour de l'ensemble formé par des bobines SPM. La portion du conducteur primaire est positionnée au voisinage, au plus près, du transducteur SPM. En pratique, la portion du conducteur primaire et le transducteur SPM ne sont de préférence séparés que par un isolant électrique. Les deux surfaces planes du circuit magnétique sont positionnées en regard et au plus près des extrémités libres du transducteur SPM. De même, les deux surfaces planes du circuit magnétique ne sont de préférence séparées des extrémités libres du transducteur SPM que par un isolant électrique.

En pratique, le circuit magnétique enserre ou entoure l'ensemble formé par le transducteur SPM et la portion du conducteur primaire de sorte à former un contour de circulation du champ magnétique. Ce contour de circulation est contenu dans un plan parallèle à l'axe central longitudinal X, entoure la portion du conducteur primaire et traverse longitudinalement le transducteur SPM en passant par les deux surfaces planes du circuit magnétique. Ainsi, le transducteur SPM fait office de capteur de circulation de champ.

En pratique, les deux faces planes du premier circuit primaire font donc face au deux faces planes du transducteur SPM.

Selon un autre mode de réalisation, le conducteur primaire peut comprendre :

- un conducteur primaire dit « aller » pour la circulation d'un courant $I_+$ dans une direction suivant un axe vertical Z perpendiculaire à l'axe central longitudinal X ; et
- un conducteur primaire dit « retour » pour la circulation d'un courant $I_-$ dans la direction opposée.

Pour un tel conducteur primaire, le transducteur SPM est avantageusement disposé entre les deux conducteurs primaires aller et retour suivant un axe latéral Y perpendiculaire aux deux axes X et Z. Le circuit magnétique entoure ainsi l'ensemble conducteurs primaires aller et retour et transducteur SPM, formant un contour perpendiculaire au sens de circulation des courants $I_+$ et $I_-$.

Selon un autre mode de réalisation, les conducteurs primaires aller et retour peuvent être formés par deux branches d'un conducteur électrique unique présentant un profil sensiblement en U. Pour un tel conducteur primaire, le transducteur SPM est disposé entre les deux branches.

Selon un autre mode de réalisation, le conducteur primaire peut être un unique conducteur. Dans ce cas de figure, le capteur peut comprendre deux transducteurs SPM disposés de part et d'autre du conducteur primaire unique et s'étendant parallèlement suivant l'axe central longitudinal X. En outre, le circuit magnétique peut être sous la forme de deux plaques formant les deux surfaces planes, une première plaque étant positionnée en regard des extrémités libres des deux transducteur SPM et une deuxième plaque étant positionnée en regard des autres extrémités libres des deux transducteurs SPM.

Selon un autre mode de réalisation, pour trois conducteurs primaires, le capteur peut comprendre deux transducteurs SPM positionnés en alternance avec lesdits conducteurs primaires suivant un axe latéral Y perpendiculaire à l'axe central longitudinal X et à l'axe Z, le circuit magnétique entourant l'ensemble formé par les trois conducteurs primaires et les deux transducteur SPM.

Le capteur peut en outre comprendre un capteur à effet Hall, et/ou des bobines de Rogowski autour de chaque conducteur primaire.

### Brève description des figures

D'autres caractéristiques et avantages de la présente invention apparaîtront plus clairement à la lecture de la description qui va suivre, faite en référence aux dessins annexés, donnés à titre d'exemples non limitatifs, dans lesquels :

La figure 1 est une courbe présentant la relation entre champ primaire $H(A/m)$ et champ mesuré $H_{mes}(A/m)$ avec un capteur en boucle ouverte basé sur un matériau SPM connu ;

La figure 2a est une représentation schématique d'un transducteur SPM selon un mode de réalisation de l'invention ;

La figure 2b est une vue en coupe suivant le plan de coupe A-A du transducteur de la figure 2a ;

La figure 3a est une représentation schématique d'un transducteur SPM selon un autre mode de réalisation de l'invention ;

La figure 3b est une représentation schématique du corps pourvu de canaux support des bobines SPM appartenant au transducteur SPM de la figure 3a ;

La figure 4a est une représentation schématique d'un capteur selon un mode de réalisation de l'invention ;

La figure 4b est une vue de dessus en coupe du capteur de la figure 4a, le circuit magnétique étant représenté schématiquement avec profil rectangulaire ;

La figure 5 est une représentation schématique d'un capteur selon un autre mode de réalisation de l'invention ;

La figure 6a est une représentation schématique du capteur selon un autre mode de réalisation intégrant des bobines de Rogowski et un capteur à effet Hall ;

La figure 6b est une vue de dessus du capteur de la figure 6a ;

La figure 7a est une représentation schématique d'un capteur selon un autre mode de réalisation de l'invention dans lequel le conducteur primaire comporte un tronçon en U ;

La figure 7b est une vue en coupe longitudinale du capteur de la figure 7a ;

La figure 7c est une vue de dessus en coupe du capteur de la figure 7a ;

La figure 8a est une représentation schématique d'un capteur selon un autre mode de réalisation de l'invention dans lequel le conducteur primaire est disposé entre deux transducteurs SPM ;

La figure 8b est une vue de dessus en coupe du capteur de la figure 8a ;

La figure 9a est une représentation schématique d'un capteur selon un autre mode de réalisation de l'invention adapté pour trois conducteurs primaires ;

La figure 9b est une vue de dessus en coupe du capteur de la figure 9a.

### Description de modes de réalisation

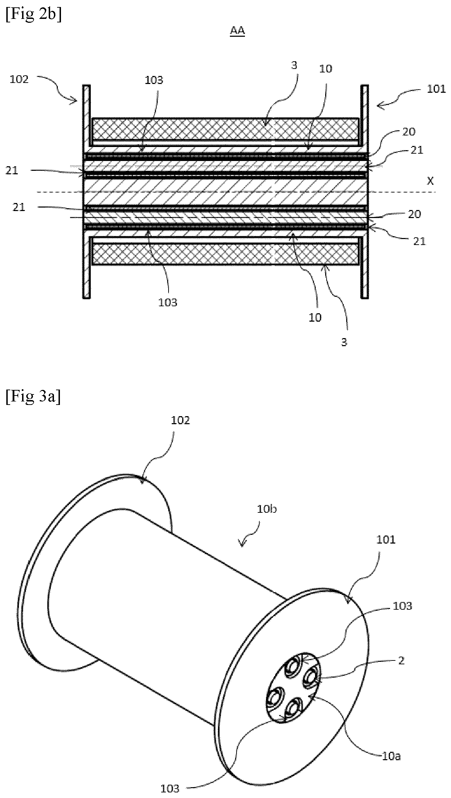

Un transducteur SPM suivant un mode de réalisation est illustré aux figures 2a et 2b.

Ce transducteur SPM 1 est formé d'un corps d'axe central longitudinal X. Le corps peut ainsi être sous la forme d'un cylindre plein, par exemple en matériau rigide à base de matière plastique.

Le corps **10** présente ainsi une surface externe **100,** un volume interne et deux faces planes **101, 102** à chacune de ses extrémités opposées suivant la direction de l'axe central longitudinal **X.** Les deux faces planes **101, 102** s'étendent sensiblement perpendiculaires à l'axe central longitudinal **X.**

Des canaux support **103** distincts sont formés dans le volume interne du corps **10,** en pratique une paire, par exemple quatre canaux support. Chaque canal support **103** est configuré pour loger une bobine SPM **2.** Les canaux support **103** s'étendent parallèlement à l'axe central longitudinal **X** et sont disposés dans le corps **10,** autour de l'axe X, symétriquement entre eux ou non, chaque canal **103** débouchant au niveau des deux faces planes **101, 102** du corps **10.**

Ainsi, les bobines SPM **2** disposées dans ces canaux **103** s'étendent parallèlement à l'axe central longitudinal **X** et débouchent également au niveau des deux faces planes **101, 102** du corps. Chaque bobine SPM **2** est notamment formée d'un noyau **20** flexible d'axe longitudinal à base de matériau SPM autour duquel est enroulé au moins un conducteur électrique **21 le** long de l'axe longitudinal du noyau **20.**

Les noyaux **20** des bobines SPM **2** peuvent présenter une section inférieure ou égale à 5 mm$^2$, de préférence inférieure ou égale à 1 mm$^2$. Les noyaux **20** des bobines SPM **2** peuvent présenter une concentration en volume de matériau SPM inférieure à 10 %, de préférence comprise entre 1 et 4 %. Ces dispositions permettent un usage réduit des matériaux SPM, particulièrement chers.

Un bobinage de contre-réaction **3** formé d'un conducteur électrique est enroulé sur la surface externe **100** du corps **10** le long de l'axe central longitudinal **X**.

Dans l'exemple illustré aux figures 2a et 2b, les faces planes **101, 102** peuvent être sous la forme de flasque de bobine ou disque de diamètre supérieur à celui du corps **10.** Ces deux faces planes **101, 102** délimitent ainsi avec la surface externe **100** du corps **10** un volume externe dans lequel est disposé le bobinage de contre-réaction **3.** En d'autres termes, le transducteur se présente sous la forme d'une canette ou tube pour bobine de câble, l'enroulement de contre-réaction étant maintenu axialement via les rebords ou flasques, et les bobines SPM étant logées dans le tube.

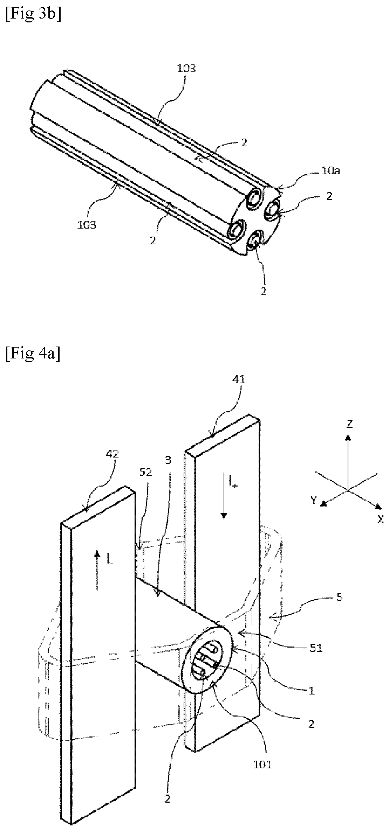

Un transducteur SPM suivant un autre mode de réalisation est illustré aux figures 3a et 3b. Dans ce mode de réalisation, le corps **10** est formé d'une première sous-structure **10a** comprenant les canaux support **103** des bobines SPM et d'une deuxième sous-structure **10b** creuse comprenant les deux faces planes **101, 102** ainsi que la surface externe **100** supportant le bobinage de contre-réaction. La première sous-structure **10a** est insérée dans le volume creux de la deuxième sous-structure **10b**. En particulier, la première sous-structure **10a** est formé d'un corps support rigide dans lequel sont creusés les canaux support qui sont ouverts radialement vers la surface externe du corps et qui débouchent aux deux extrémités du corps.

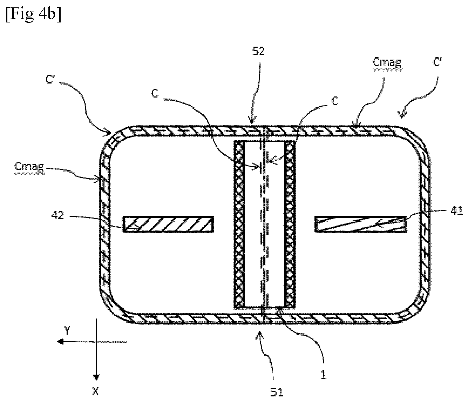

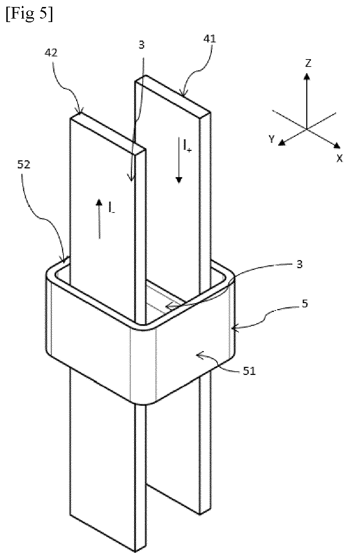

Un capteur de circulation du champ magnétique pour la mesure de courant continu suivant un mode de réalisation est illustré aux figures 4a, 4b et 5. Ce capteur de courant comprend un transducteur SPM **1** qui peut être de structure similaire au transducteur décrit ci-avant et qui s'étend suivant un axe longitudinal **X**. Le transducteur SPM 1 est notamment sous la forme d'un corps cylindrique portant à l'extérieur un bobinage de contre-réaction **3** et à l'intérieur un dispositif de mesure de circulation du champ magnétique sous la forme de bobines SPM **2,** par exemple deux paires de bobine SPM. Ce capteur est configuré pour être positionné autour d'une portion d'un conducteur électrique primaire qui peut être formé d'un conducteur primaire dit « aller » **41** et d'un conducteur primaire dit « retour » **42,** traversés respectivement par des courants **I₊** et **I₋** circulant en sens opposée. Les deux conducteurs primaires aller et retour **41, 42** s'étendent perpendiculairement à l'axe longitudinal **X** dans une direction suivant un axe **Z** et sont disposés de part et d'autre du transducteur SPM suivant un axe latéral **Y** perpendiculaire aux axes **X** et **Z**. L'axe Z est vertical au regard du capteur présenté sur la figure.

Le circuit magnétique **5** entoure l'ensemble conducteur primaire aller et retour **41, 42** et transducteur SPM **1,** formant un contour perpendiculaire au sens de circulation des courants **I₊** et **I₋**. Le circuit magnétique **5** comprend deux portions ou surfaces planes **51, 52** positionnées en regard des extrémités libres **101, 102** respectives du transducteurs SPM **1,** ces extrémités libres **101, 102** étant avantageusement des faces planes telles que décrites ci-avant. La hauteur (suivant l'axe **Z**) et la longueur (suivant l'axe **Y**) d'une surface plane **51, 52** du circuit magnétique **5,** sont telles que la surface plane **51, 52** recouvre au moins la face plane de l'extrémité libre du transducteur SPM. La taille de la surface plane **51, 52** peut résulter d'un compromis entre performance et volume de matériau magnétique impactant sur le prix, l'encombrement et le poids du capteur. En pratique, un isolant électrique est intercalé entre les différents éléments du capteur, de sorte que le circuit magnétique est de préférence collé à l'isolant électrique, pour être au plus près de l'ensemble conducteur primaire et transducteur SPM.

Ainsi, dans ce mode de réalisation, la paire de conducteurs primaires aller et retour **41, 42** est entourée par un circuit magnétique **5** présentant au moins deux surfaces planes **51, 52** parallèles entre elles. Un transducteur SPM **1** constitué de bobines SPM rectilignes est inséré entre les deux conducteurs primaires aller et retour **41, 42** de manière à créer un contour ouvert de mesure C reliant les deux surfaces faces **51, 52** planes du circuit magnétique **5.** Le contour ouvert de mesure C (figure 4b) est ici similaire à un chemin passant aux deux extrémités du transducteur SPM et s'étendant dans l'axe **X**.

En pratique, le conducteur primaire aller **41** est parcouru par un courant $I_+ = I_p$ pouvant varier en utilisation normale entre des valeurs $-I_{max}$ et $+I_{max}$, et le conducteur primaire retour **42** est parcouru par un courant $I_- = -I_p$. Le bobinage de contre-réaction **3** est parcouru par un courant $I_{CR}$, et est formé d'un enroulement de N tours enroulé autour d'un support creux contenant des bobines SPM **2** classiques pour la mesure de la circulation *cir* d'un champ magnétique H sur le contour ouvert C. La circulation *cir* est donnée par l'équation :

$$cir = \oint_C \vec{H}\,\vec{dl}$$

Le courant de contre-réaction $I_{CR}$ est de préférence ajusté en permanence de manière à obtenir une circulation *cir* = 0, de sorte que $N.I_{CR} = -I_p$.

Le matériau SPM est de préférence un matériau SPM à forte sensibilité caractérisé par un champ maximum d'utilisation $H_{max}$ sensiblement inférieur au champ maximum $H_{pmax}$ généré par les conducteurs primaires.

La forme et les dimensions du circuit magnétique et de la bobine de contre-réaction sont de préférence ajustés de manière à obtenir des fluctuations du champ magnétique le long du contour ouvert C inférieures au champ maximum d'utilisation $H_{max}$, lorsque *cir = 0* et $I_p=I_{Pmax}$.

A titre d'exemple, le contour ouvert C est de préférence de longueur réduite, par exemple de l'ordre de 50mm. Les deux surfaces planes **51, 52** du circuit magnétique **5** peuvent ainsi être considérées comme distantes d'environ 50 mm suivant l'axe **X**.

Si on considère un contour fermé *C'* constitué d'une part du contour ouvert *C* et d'une portion de contour *C$_{mag}$* reliant les deux surfaces planes **51, 52** et entourant le conducteur primaire aller **41** ou retour **42**, alors le théorème d'Ampère conduit à :

$$\oint_{C'} \vec{H}\, \vec{dl} = \oint_{C} \vec{H}\, \vec{dl} + \oint_{C_{mag}} \vec{H}\, \vec{dl} = I_P \;;$$

avec *H* le champ magnétique, et *I$_p$* le courant circulant dans le conducteur primaire considéré.

Si la perméabilité relative $\mu_r$ et/ou l'épaisseur du matériau magnétique est suffisamment élevée, on peut négliger le deuxième terme, de sorte à ne considérer que :

$$\oint_{C} \vec{H}\, \vec{dl} = I_P$$

En outre, si le bobinage de contre-réaction qui entoure les bobines SPM est parcouru par un courant générant $I_{CR}$ Ampères tours, alors :

$$\oint_{C} \vec{H}\, \vec{dl} = I_P + I_{CR}$$

Lorsque le capteur de circulation, c'est-à-dire le transducteur SPM, fourni une valeur nulle, on a donc : $I_{CR} = -I_P$.

Le bobinage de contre-réaction doit ainsi être capable de générer 500A.t pour un courant primaire de 500A, et le taux de remplissage moyen d'un bobinage est autour de $K_r = 0,6$. Si on se limite à une densité de courant de $J_{max}$ = 5 A/mm$^2$, il faudra donc de préférence une section de bobinage minimale $S_{Bobine}$ de :

$$S_{Bobine} = \frac{I_{pmax}}{K_r J_{max}} = \frac{500}{5 \times 0,6} = 167\ mm^2$$

Soit une épaisseur de bobinage comprise entre 3 et 4mm.

Un tel bobinage de contre-réaction de 3 à 4mm est difficilement réalisable directement sur une bobine SPM de l'art antérieur qui est traditionnellement réalisée sur un cœur de faible section, de l'ordre de 1mm.

L'invention propose ainsi une nouvelle configuration dans laquelle la contre-réaction est générée au moyen d'une bobine de plus grosse section, dont le cœur de bobinage est creux et peut accueillir les bobines SPM de mesure, comme illustré sur les figures 2a-3b.

En ajustant correctement les paramètres géométriques du circuit magnétique **5** et de la bobine de contre-réaction **3**, il est possible de réduire la fluctuation des champs le long du contour ouvert C.

Le matériau du circuit magnétique est de préférence à base d'un matériau à forte perméabilité et faible champ coercitif (par exemple à base de FeNi 80%). En effet, l'absence d'offset magnétique des bobines SPM ne signifie pas l'absence d'offset magnétique du dispositif. Le matériau du noyau SPM est caractérisé par son champ coercitif $H_C$, et en l'absence de courant, on a :

$$\oint_{C} \vec{H}\, \vec{dl} + \oint_{C_{mag}} \vec{H}\, \vec{dl} = 0$$

Le champ à l'intérieur du matériau étant compris entre $+H_C$ et $-H_C$, il est possible d'écrire :

$$\left| \oint_{C_{mag}} \vec{H}\, \vec{dl} \right| < \oint_{C_{mag}} \vec{H_C}\, \vec{dl} = H_c l_{mag}$$

où $l_{mag}$ est la longueur du circuit magnétique 5 permettant de refermer le contour C.

Le courant résultant $I_0$ peut donc être borné par $I_0 < H_c\, l_{mag}$

Ainsi, pour réduire $I_0$, on peut choisir un matériau à faible champ coercitif, par exemple un alliage de type FeNi à 80% de Ni pour $H_c$ = 0.6A/m

En outre, pour réduire $l_{mag}$, une solution consiste à orienter les conducteurs primaires aller et retour comme sur la figure 5, lorsque ces conducteurs présentent des sections rectangulaires. De cette manière, le circuit magnétique 5 est plus compact.

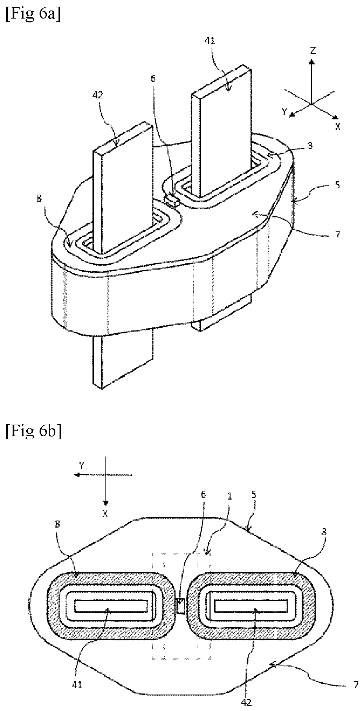

Dans certaines applications, il peut également être intéressant, notamment à des fins de protection, de pouvoir mesurer des courants de surcharge supérieurs au courant maximum compensable par le courant de contre-réaction. A cet effet, comme illustré sur les figures 6a et 6b, il est possible de disposer un capteur à effet Hall **6** entre les deux conducteurs primaires **41, 42.** Ce capteur à effet Hall **6** sera avantageusement supporté par un circuit imprimé **7** configuré pour connecter le transducteur SPM.

Enfin, des courants de court-circuit peuvent être mesurés par des dispositifs de type bobine ou enroulement de Rogowski **8.** Ainsi, avantageusement, le capteur peut intégrer une ou plusieurs bobines de Rogowski **8,** chacune placée autour d'un des conducteurs primaires **41, 42.** Ces bobines de Rogowski **8** peuvent avantageusement être intégrées dans le circuit imprimé **8.** A titre d'exemple, la bobine de Rogowski sous la forme d'un circuit imprimé décrit dans le document EP 3 268 754 et/ou le capteur à effet Hall décrit dans le document FR 2 947 060 peuvent être mis en œuvre dans le capteur de l'invention, sans que ces exemples ne soient limitatifs puisque tout type de capteur du commerce peut convenir.

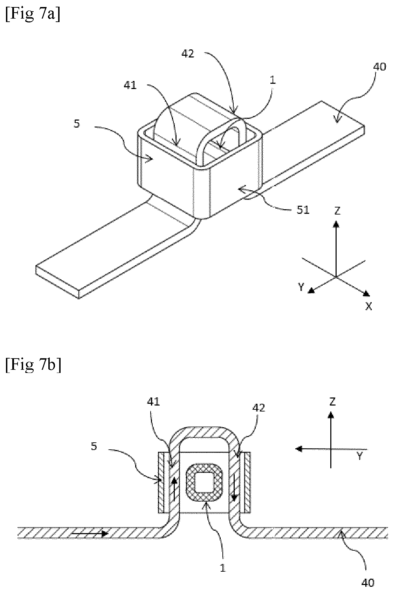

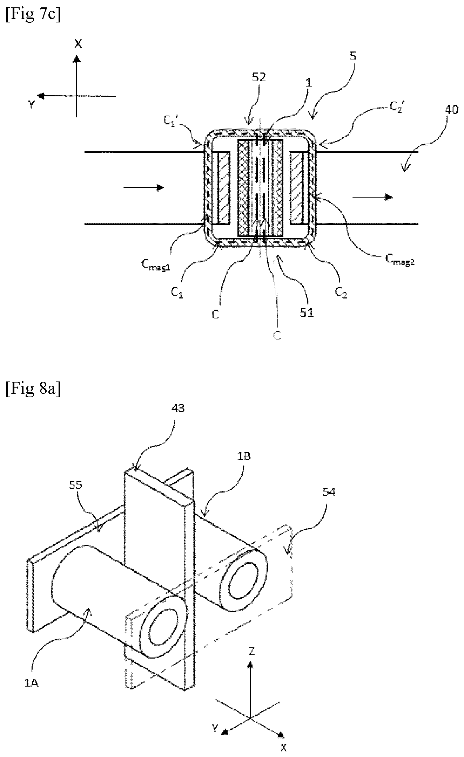

Selon un autre mode de réalisation illustré aux figures 7a-7c, les conducteurs primaires aller et retour **41, 42** peuvent être formés par deux branches d'un conducteur électrique **40** unique présentant un profil sensiblement en U. Le transducteur SPM **1** est disposé entre les deux branches du U, et le circuit magnétique **5** entoure les deux branches. Ainsi, il est possible d'identifier deux contours de circulation $C_1'$ et $C_2'$ pour la réalisation de mesure. Un premier contour $C_1'$ de circulation du champ entourant une branche **41** du conducteur primaire, est formé par un contour ouvert $C$ et un contour ouvert $C_{mag1}$. Le contour de mesure C passe le long du transducteur SPM 1 et relie les deux surfaces faces **51, 52** planes du circuit magnétique **5,** et le contour $C_{mag1}$ circule sur une portion du circuit magnétique reliant les deux surfaces planes **51, 52** et entoure une branche du conducteur primaire. Un deuxième contour $C_2'$ de circulation du champ entourant une autre branche **42** du conducteur primaire, est formé par le contour ouvert $C$ et un deuxième contour ouvert $Cmag2$ circulant sur une autre portion du circuit magnétique **5** reliant les deux surfaces planes **51, 52** et entourant l'autre branche du conducteur primaire.

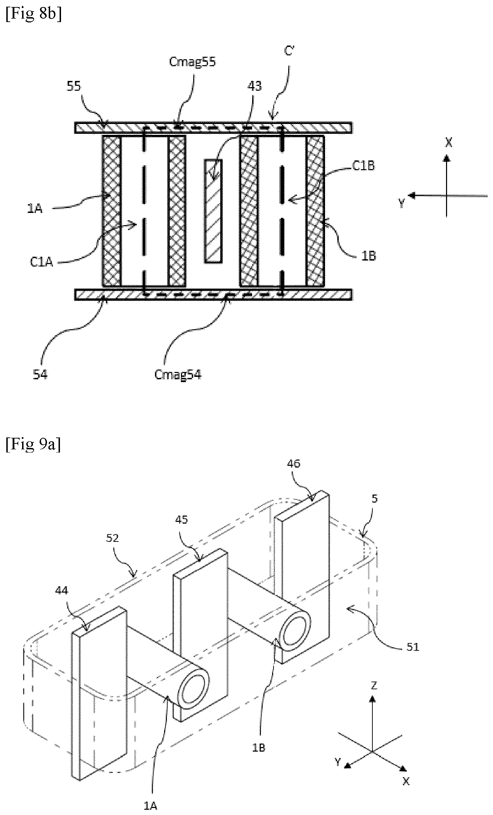

Selon un autre mode de réalisation illustré aux figures 8a et 8b, le conducteur primaire est formé d'un unique conducteur **43** disposé entre deux transducteurs SPM **1A** et **1B.** Les deux transducteurs SPM **1A, 1B** sont sensiblement identiques. Le circuit magnétique est formé de deux plaques **54, 55,** formant les deux surfaces planes. Une première plaque **54** est positionnée en regard d'une des extrémités libres des deux transducteur SPM **1A, 1B** et une deuxième plaque **55** est positionnée en regard des autres extrémités libres des deux transducteurs SPM **1A, 1B.** Comme illustré sur la figure 8b, le contour C' de mesure est formé par les deux contours **C1A** et **C1B** circulant le long des deux transducteurs SPM **1A** et **1B** respectifs et les contours **Cmag54** et **Cmag55** circulant dans les plaques **54** et **55** respectives. Le contour C' est ainsi un contour fermé entourant le conducteur primaire **43.**

Dans certains types d'application à courant continu, le nombre de conducteurs primaire peut être au nombre de trois : un premier conducteur primaire $P_0$ sert notamment de référence (0Volt), un deuxième conducteur primaire $P_+$ est destiné à être parcouru par un courant $I_+$ et un troisième conducteur primaire $P_-$ destiné à être parcouru par un courant $I_-$ de sens opposée au courant $I_+$. En pratique, les courants $I_+$ et $I_-$ ne sont pas nécessairement de même amplitude, de sorte qu'il peut exister un courant $I_0$ dans le premier conducteur primaire de référence, tel que $I_0 + I_+ + I_- = 0$ en l'absence de courant de fuite.

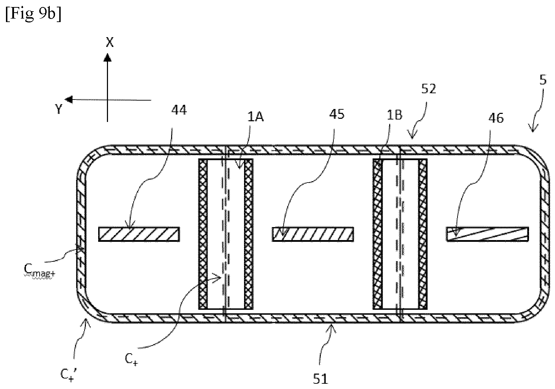

La configuration illustré aux figures 9a et 9b permet de répondre à cette problématique, suivant le même principe que les modes de réalisation précédents. Ainsi, trois conducteurs primaires **44, 45** et **46** sont disposés en alternance avec deux transducteurs SPM **1A, 1B,** et un circuit magnétique **5** entoure l'ensemble. Ainsi, chaque transducteur SPM **1A, 1B** est disposé entre deux conducteurs primaires **44, 45, 46,** et s'étend parallèlement à l'axe X. En outre, comme pour les modes de réalisation précédents, le circuit magnétique **5** (dessiné en pointillés sur la figure 9a) comprend deux surfaces planes **51, 52** positionnées en regard des deux extrémités libres des transducteurs SPM de manière à former les différents contours.

Le premier conducteur primaire **44** peut être le conducteur $P_+$ destiné à être parcouru par un courant $I_+$, le deuxième conducteur **45** peut être le conducteur de référence $P_0$, et le troisième conducteur **46** peut être le conducteur $P_-$ destiné à être parcouru par un courant $I_-$.

Pour le capteur de circulation placé entre les conducteurs $P_+$ et $P_0$, c'est-à-dire le transducteur SPM **1A,** la circulation de champ mesurée sur le chemin formé par le contour C+' formé par le chemin $C_+$ le long du transducteur SPM **1A** et par le chemin $C_{mag+}$ à travers la portion gauche du circuit magnétique **5** pour entourer le conducteur $P_+$, en absence de courant de contre-réaction, se traduit par :

$$\oint_{C_+} \vec{H}\,\vec{dl} + \oint_{C_{mag+}} \vec{H}\,\vec{dl} = I_+$$

Comme la circulation dans le matériau du circuit magnétique peut être considérée comme négligeable, la circulation mesurée sur le chemin C+ est ainsi sensiblement égale à $I_+$. Lorsqu'on applique le même nombre d'Ampère tours dans la contre-réaction, on obtient une circulation nulle. Le même raisonnement s'applique au transducteur SPM **1B** placé entre les conducteurs $P_0$ et $P_-$.

La présente invention n'est bien entendu pas limitée aux exemples de réalisation décrits mais s'étend à toute modification et variante évidentes pour un homme du métier dans la limite des revendications annexées. En outre, les caractéristiques techniques des différents modes de réalisation et variantes mentionnés ci-dessus peuvent être, en totalité ou pour certaines d'entre elles, combinées entre elles.

**Revendications**

1. Capteur de circulation du champ magnétique pour la mesure d'un courant continu, formé d'au moins un transducteur à matériau superparamagnétique SPM destiné à être soumis à un champ magnétique extérieur à mesurer induit par un courant traversant un conducteur primaire (40-46) formé d'au moins un conducteur électrique dont au moins une portion s'étend suivant un axe (Z), le capteur comprenant au moins un transducteur SPM (1) à matériau superparamagnétique SPM comprenant :

    . au moins une bobine SPM (2) formée d'un noyau (20) d'axe longitudinal à base de matériau SPM autour duquel est enroulé au moins un conducteur électrique le long de l'axe longitudinal ; et

. au moins un bobinage de contre-réaction (3) ;

. un corps (10) rigide d'axe central longitudinal (X), et deux faces planes (101, 102) à chacune des extrémités opposées du corps (10) suivant la direction de l'axe centrale longitudinal (X), ces deux faces planes (101, 102) étant sensiblement perpendiculaires à l'axe central longitudinal (X) ;

. au moins un canal support (103) formé dans le corps (10) et dans lequel est logé la bobine SPM (2), le canal support (103) s'étendant parallèlement à l'axe central longitudinal (X) et débouchant sur les deux faces planes (101, 102) ;

et le bobinage de contre-réaction (3) étant formé d'un conducteur électrique enroulé sur la surface externe du corps (10) et le long de l'axe central longitudinal (X),

ledit transducteur présentant deux extrémités libres opposées suivant l'axe central longitudinal (X), le transducteur SPM (1) étant formé du bobinage de contre-réaction (3) couplé à ladite au moins une bobine SPM (2) s'étendant entre les deux extrémités libres ;

ledit capteur comportant un circuit magnétique (5) présentant au moins deux surfaces planes (51, 52) parallèles entre elles et perpendiculaires à l'axe central longitudinal (X), les deux surfaces planes (51, 52) étant positionnées en regard des extrémités libres respectives du transducteur SPM (1) ;

ledit capteur étant configuré pour être positionné par rapport audit conducteur primaire (40-46) de sorte que ledit axe (Z) est perpendiculaire à l'axe longitudinal (X) et parallèle auxdites surfaces planes (51, 52).

2. Capteur de circulation du champ magnétique selon la revendication 1, **caractérisé en ce que** le transducteur comprend en outre plusieurs canaux support (103) distincts, chaque canal (103) logeant une bobine SPM (2), les canaux support (103) s'étendant parallèlement à l'axe central longitudinal (X) et étant disposés dans le corps (10) autour de l'axe central longitudinal (X), chaque canal (103) débouchant au niveau des deux faces planes (101, 102) du corps.

3. Capteur de circulation du champ magnétique selon l'une quelconque des revendications 1 à 2, **caractérisé en ce que** le noyau (20) de ladite au moins une bobine SPM (2) présente une section inférieure ou égale à 5 mm$^2$, et une concentration en volume de matériau SPM inférieure à 10 %.

4. Capteur de circulation du champ magnétique selon l'une quelconque des revendications 1 à 3, **caractérisé en ce que** les deux faces planes (101, 102) délimitent avec la surface externe (100) du corps

(10) un volume externe, le bobinage de contre-réaction (3) étant contenu dans ce volume externe.

5. Capteur de circulation du champ magnétique selon l'une des revendications 1 à 4, **caractérisé en ce que** le corps (10) est formé d'une première sous-structure (10a) comprenant ledit au moins un canal support (103) et d'une deuxième sous-structure (10b) creuse comprenant les deux faces planes (101, 102) ainsi que la surface externe (100) supportant le bobinage de contre-réaction (3), la première sous-structure (10a) étant insérée dans le volume creux de la deuxième sous-structure (10b), ledit au moins un canal support (103) étant ouvert radialement vers la surface externe du corps de la première sous-structure (10a) et débouchant aux deux extrémités dudit corps de la première sous-structure (10a).

6. Capteur de circulation du champ magnétique selon l'une des revendications 1 à 5, **caractérisé en ce que** pour un conducteur primaire comprenant :

- un conducteur primaire dit « aller » (41) pour la circulation d'un courant dans une direction suivant l'axe Z ; et
- un conducteur primaire dit « retour » (42) pour la circulation d'un courant dans la direction opposée ;

le transducteur SPM (1) est disposé entre les deux conducteurs primaires aller et retour (41, 42) suivant un axe latéral (Y) perpendiculaire à l'axe central longitudinal (X) et à l'axe (Z), le circuit magnétique (5) entourant l'ensemble conducteurs primaires aller et retour (41, 42) et transducteur SPM (1), formant un contour de circulation de champ perpendiculaire au sens de circulation des courants.

7. Capteur de circulation du champ magnétique selon la revendication 6, **caractérisé en ce que** pour des conducteurs primaires aller et retour (41, 42) formés par les deux branches d'un conducteur électrique unique présentant un profil sensiblement en U, le transducteur SPM (1) est disposé entre les deux branches.

8. Capteur de circulation du champ magnétique selon l'une des revendications 1 à 5, **caractérisé en ce que**, pour un unique conducteur primaire (43), deux transducteurs SPM (1A, 1B) sont disposés de part et d'autre du conducteur primaire (43) et s'étendent parallèlement suivant l'axe central longitudinal (X), et le circuit magnétique (5) comprend deux plaques (54, 55) formant les deux surfaces planes (51, 52), l'une des plaques (51) étant positionnée en regard des extrémités libres des deux transducteur SPM (1A, 1B), et l'autre plaque (55) étant positionnée en regard des autres extrémités libres des deux transducteurs SPM (1A, 1B).

9. Capteur de circulation du champ magnétique selon l'une des revendications 1 à 5, **caractérisé en ce que**, pour trois conducteurs primaires (44, 45, 46), le capteur comprend deux transducteurs SPM (1A, 1B) positionnés en alternance avec lesdits conducteurs primaires (44, 45, 46) suivant un axe latéral (Y) perpendiculaire à l'axe central longitudinal (X) et à l'axe (Z), le circuit magnétique (5) entourant l'ensemble formé par les trois conducteurs primaires (44, 45, 46) et les deux transducteur SPM (1A, 1B).

10. Capteur de circulation du champ magnétique selon l'une des revendications 1 à 9, **caractérisé en ce que** le capteur comprend en outre un capteur à effet Hall (7) et/ou des bobines de Rogowski (9) autour de chaque conducteur primaire.

**Patentansprüche**

1. Magnetfeld-Flusssensor zur Messung eines Gleichstroms, der als mindestens ein Wandler mit superparamagnetischem SPM-Material ausgebildet ist, der einem zu messenden externen Magnetfeld ausgesetzt wird, das durch einen Strom induziert wird, der durch einen Primärleiter (40-46) fließt, der aus mindestens einem elektrischen Leiter besteht, von dem sich mindestens ein Abschnitt ab einer Achse (Z) entlang erstreckt, wobei der Sensor mindestens einen SPM-Wandler (1) aus superparamagnetischem SPM-Material aufweist, der Folgendes umfasst:

. mindestens eine SPM-Spule (2), die aus einem Kern (20) mit einer Längsachse aus SPM-Material besteht, um den mindestens ein elektrischer Leiter entlang der Längsachse gewickelt ist; und
. mindestens eine Rückkopplungswicklung (3);
. einen starren Körper (10) mit einer zentralen Längsachse (X) und zwei ebenen Flächen (101, 102) an den beiden gegenüberliegenden Enden des Körpers (10) in Richtung der zentralen Längsachse (X), wobei diese beiden ebenen Flächen (101, 102) im Wesentlichen senkrecht zur zentralen Längsachse (X) angeordnet sind;
. mindestens einen im Körper (10) ausgebildeten Trägerkanal (103), in dem sich die SPM-Spule (2) befindet, wobei sich der Trägerkanal (103) parallel zur zentralen Längsachse (X) erstreckt und an den beiden ebenen Flächen (101, 102) mündet;
wobei die Rückkopplungswicklung (3) aus einem elektrischen Leiter besteht, der auf die Außenfläche des Körpers (10) und an der zentralen Längsachse (X) entlang gewickelt ist,

wobei der Wandler zwei freie Enden aufweist, die entlang der zentralen Längsachse (X) gegenüberliegen, und der SPM-Wandler (1) aus der Rückkopplungswicklung (3) besteht, die mit der mindestens einen SPM-Spule (2) gekoppelt ist, die sich zwischen den beiden freien Enden erstreckt;
wobei der Sensor einen Magnetkreis (5) mit mindestens zwei zueinander parallelen und zur zentralen Längsachse (X) senkrechten ebenen Flächen (51, 52) aufweist, und die beiden ebenen Flächen (51, 52) gegenüber den jeweiligen freien Enden des SPM-Wandlers (1) angeordnet sind;
wobei der Sensor in Bezug auf den Primärleiter (40-46) in der Weise konfiguriert und angeordnet ist, dass die Achse (Z) senkrecht zur Längsachse (X) und parallel zu den ebenen Flächen (51, 52) ist.

2. Magnetfeld-Flusssensor nach Anspruch 1, **dadurch gekennzeichnet, dass** der Wandler außerdem mehrere separate Trägerkanäle (103) umfasst, wobei in jedem Kanal (103) eine SPM-Spule (2) untergebracht ist, die Trägerkanäle (103) sich parallel zur zentalen Längsachse (X) erstrecken und im Körper (10) um die zentrale Längsachse (X) angeordnet sind, wobei jeder Kanal (103) an den beiden ebenen Flächen (101, 102) des Körpers mündet.

3. Magnetfeld-Flusssensor nach einem der Ansprüche 1 bis 2, **dadurch gekennzeichnet, dass** der Kern (20) der mindestens einen SPM-Spule (2) einen Querschnitt von weniger als oder gleich 5 mm$^2$ und eine Volumenkonzentration an SPM-Material von weniger als 10 % aufweist.

4. Magnetfeld-Flusssensor nach einem der Ansprüche 1 bis 3, **dadurch gekennzeichnet, dass** die beiden ebenen Flächen (101, 102) zusammen mit der Außenfläche (100) des Körpers (10) ein Außenvolumen begrenzen, wobei die Rückkopplungswicklung (3) in diesem Außenvolumen enthalten ist.

5. Magnetfeld-Flusssensor nach einem der Ansprüche 1 bis 4, **dadurch gekennzeichnet, dass** der Körper (10) eine erste Unterstruktur (10a) mit dem mindestens einen Trägerkanal (103) und eine zweite hohle Unterstruktur (10b) mit den beiden ebenen Flächen (101, 102) und der Außenfläche (100) umfasst, welche die Rückkopplungswicklung (3) trägt, wobei die erste Unterstruktur (10a) in den Hohlraum der zweiten Unterstruktur (10b) eingesetzt ist, und der mindestens eine Trägerkanal (103) radial zur Außenfläche des Körpers der ersten Unterstruktur (10a) offen ist und an beiden Enden des Körpers der ersten Unterstruktur (10a) mündet.

**6.** Magnetfeld-Flusssensor nach einem der Ansprüche 1 bis 5, **dadurch gekennzeichnet, dass** der SPM-Wandler (1) bei einem Primärleiter mit:

- einem sogenannten "Hinstrom"-Primärleiter (41) für den Stromfluss in Richtung der Z-Achse; und
- einem sogenannten "Rückstrom"-Primärleiter (42) für den Stromfluss in entgegengesetzter Richtung;

zwischen den beiden Primärleitern für den Hin- und Rückstrom (41, 42) entlang einer seitlichen Achse (Y) angeordnet ist, die senkrecht zur zentralen Längsachse (X) und zur Achse (Z) steht, wobei der Magnetkreis (5) die Baugruppe der Primärleiter für den Hin- und Rückstrom (41, 42) und den SPM-Wandler (1) umschließt, die eine Feldströmungskontur bilden, die senkrecht zur Richtung der Stromflüsse verläuft.

**7.** Magnetfeld-Flusssensor nach Anspruch 6, **dadurch gekennzeichnet, dass** der SPM-Wandler (1) bei den Primärleitern für den Hin- und Rückstrom (41, 42), die durch die beiden Zweige eines einzigen elektrischen Leiters mit einem im Wesentlichen U-förmigen Profil gebildet werden, zwischen den beiden Zweigen angeordnet ist.

**8.** Magnetfeld-Flusssensor nach einem der Ansprüche 1 bis 5, **dadurch gekennzeichnet, dass** zwei SPM-Wandler (1A, 1B) für einen einzigen Primärleiter (43) auf beiden Seiten des Primärleiters (43) angeordnet sind und sich parallel zur zentralen Längsachse (X) erstrecken, und der Magnetkreis (5) zwei Platten (54, 55) umfasst, die die beiden ebenen Flächen (51, 52) bilden, wobei eine der Platten (51) gegenüber den freien Enden der beiden SPM-Wandler (1A, 1B) angeordnet ist und die andere Platte (55) gegenüber den anderen freien Enden der beiden SPM-Wandler (1A, 1B) angeordnet ist.

**9.** Magnetfeld-Flusssensor nach einem der Ansprüche 1 bis 5, **dadurch gekennzeichnet, dass** der Sensor bei drei Primärleitern (44, 45, 46) zwei SPM-Wandler (1A, 1B) umfasst, die abwechselnd mit den Primärleitern (44, 45, 46) an einer seitlichen Achse (Y) entlang, senkrecht zur zentralen Längsachse (X) und zur Achse (Z) angeordnet sind, wobei der Magnetkreis (5), der die Baugruppe umgibt, durch die drei Primärleiter (44, 45, 46) und die beiden SPM-Wandler (1A, 1B) gebildet wird.

**10.** Magnetfeld-Flusssensor nach einem der Ansprüche 1 bis 9, **dadurch gekennzeichnet, dass** der Sensor zusätzlich einen Hall-Sensor (7) und/oder Rogowski-Spulen (9) um jeden Primärleiter herum umfasst.

**Claims**

**1.** A magnetic field flow sensor for measuring a direct current, formed by at least one SPM super-paramagnetic material transducer intended to be subjected to an external magnetic field to be measured induced by a current traversing a primary conductor (40-46) formed by at least one electrical conductor of which at least a portion extends along an axis (Z), the sensor comprising at least one SPM super-paramagnetic material SPM transducer (1) comprising:

. at least one SPM coil (2) formed by a core (20) with a longitudinal axis made of SPM around which at least one electrical conductor is wound, along the longitudinal axis; and
. at least one feedback winding (3);
. a rigid body (10) with a longitudinal central axis (X), and two planar surfaces (101, 102) at each of the opposite ends of the body (10) in the direction of the longitudinal central axis (X), both of these planar surfaces (101, 102) being substantially perpendicular to the longitudinal central axis (X);
. at least one support channel (103) formed in the body (10) and in which the SPM coil (2) is housed, the support channel (103) extending parallel to the longitudinal central axis (X) and opening onto both planar surfaces (101, 102);
the feedback winding (3) being formed by an electrical conductor wound onto the outer surface of the body (10) and along the longitudinal central axis (X),
said transducer having two opposite free ends along the longitudinal central axis (X), the SPM transducer (1) being formed by the feedback winding (3) coupled to said at least one SPM coil (2) extending between both free ends;
said sensor comprising a magnetic circuit (5) having at least two planar surfaces (51, 52) parallel to one another and perpendicular to the longitudinal central axis (X), both planar surfaces (51, 52) being positioned opposite the respective free ends of the SPM transducer (1);
said sensor being configured to be positioned relative to said primary conductor (40-46) such that said axis (Z) is perpendicular to the longitudinal axis (X) and parallel to said planar surfaces (51, 52).

**2.** The magnetic field flow sensor according to Claim 1, **characterised in that** the transducer further comprises several distinct support channels (103), each channel (103) housing an SPM coil (2), the support channels (103) extending parallel to the longitudinal central axis (X) and being arranged in the body (10) around the longitudinal central axis (X), each channel (103) opening at both planar surfaces (101, 102) of the body.

3. The magnetic field flow sensor according to any one of Claims 1 to 2, **characterised in that** the core (20) of said at least one SPM coil (2) has a cross-section of less than or equal to 5 mm², and an SPM material volume concentration of less than 10%.

4. The magnetic field flow sensor according to any one of Claims 1 to 3, **characterised in that** both planar surfaces (101, 102) form an external volume with the external surface (100) of the body (10), the feedback winding (3) being contained in this external volume.

5. The magnetic field flow sensor according to any one of Claims 1 to 4, **characterised in that** the body (10) is formed by a first sub-structure (10a) comprising said at least one support channel (103) and a second hollow sub-structure (10b) comprising both planar surfaces (101, 102) as well as the external surface (100) supporting the feedback winding (3), the first sub-structure (10a) being inserted into the hollow volume of the second sub-structure (10b), said at least one support channel (103) being open radially towards the external surface of the body of the first sub-structure (10a) and opening at both ends of said body of the first sub-structure (10a).

6. The magnetic field flow sensor according to one of Claim 1 to 5, **characterised in that** for a primary conductor comprising:

    - a primary conductor referred to as an "outward" conductor (41), for the flow of a current in a direction along the Z axis; and
    - a primary conductor referred to as a "return" conductor (42), for the flow of a current in the opposite direction;

    the SPM transducer (1) is arranged between both of the primary outward and return conductors (41, 42) along a lateral axis (Y) perpendicular to the longitudinal central axis (X) and to the axis (Z), the magnetic circuit (5) surrounding the assembly of primary outward and return conductors (41, 42) and SPM transducer (1), forming a field flow contour perpendicular to the flow direction of the currents.

7. The magnetic field flow sensor according to Claim 6, **characterised in that** for outward and return primary conductors (41, 42) formed by both branches of a single electrical conductor having a substantially U-shaped profile, the SPM transducer (1) is arranged between both branches.

8. The magnetic field flow sensor according to any one of Claims 1 to 5, **characterised in that**, for a single primary conductor (43), two SPM transducers (1A, 1B) are arranged on either side of the primary conductor (43) and extend parallel along the longitudinal central axis (X), and the magnetic circuit (5) comprises two plates (54, 55) forming both planar surfaces (51, 52), one of the plates (51) being positioned opposite the free ends of both SPM transducers (1A, 1B), and the other plate (55) being positioned opposite the other free ends of both SPM transducers (1A, 1B).

9. The magnetic field flow sensor according to any one of Claim 1 to 5, **characterised in that**, for three primary conductors (44, 45, 46), the sensor comprises two SPM transducers (1A, 1B) positioned alternately with said primary conductors (44, 45, 46) along a lateral axis (Y) perpendicular to the longitudinal central axis (X) and to the axis (Z), the magnetic circuit (5) surrounding the assembly formed by the three primary conductors (44, 45, 46) and both SPM transducers (1A, 1B).

10. The magnetic field flow sensor according to any one of Claims 1 to 9, **characterised in that** the sensor further comprises a Hall effect sensor (7) and/or Rogowski coils (9) around each primary conductor.

[Fig 1]

[Fig 2a]

[Fig 2b]

[Fig 3a]

[Fig 3b]

[Fig 4a]

[Fig 4b]

[Fig 5]

EP 4 587 848 B1

[Fig 6a]

[Fig 6b]

17

[Fig 7a]

[Fig 7b]

[Fig 7c]

[Fig 8a]

[Fig 8b]

[Fig 9a]

[Fig 9b]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2891917
- EP 3477311 B1
- US 2012038360 A1
- WO 2022129732 A1
- EP 3268754 A
- FR 2947060